# EUROPEAN PATENT APPLICATION

(11) **EP 2 398 047 A2**
(43) Date of publication of application: **21.12.2011**
(21) Application number: 11156820.0
(22) Date of filing: 03.03.2011
(51) Int. Cl.: H01L 21/687

(54) **Susceptor and Chemical Vapor Deposition Apparatus including the same**

(30) Priority: 15.06.2010 KR 20100056691
(71) Applicant: Samsung LED Co., Ltd., Gyeonggi-do, 443-743 (KR)
(72) Inventor: Kim, Young-ki, Gyeonggi-do (KR); Jung, Ho-il, Gyeonggi-do (KR); Koh, Chong-mann, Gyeonggi-do (KR); Han, Sung-il, Gyeonggi-do (KR)
(74) Representative: Greene, Simon Kenneth

(57) **Abstract**

A susceptor and a chemical vapor deposition (CVD) apparatus including the same. The susceptor has a shape of a disk with a hollow and includes a plurality of pockets formed in an upper surface of the susceptor to accommodate deposition targets; and susceptor channels formed in the susceptor to supply a flowing gas to the plurality of pockets. Inlets of the susceptor channels are formed in a sidewall of the hollow. Alternatively, the inlets of the susceptor channels are formed in a lower surface of the susceptor and a reinforcement unit is further formed.

## Description

### BACKGROUND

### 1. Field

The present disclosure relates to susceptors and chemical vapor deposition (CVD) apparatuses including the same.

### 2. Description of the Related Art

In general, chemical vapor deposition (CVD) apparatuses are apparatuses for forming thin films on deposition targets (generally including substrates such as semiconductor wafers) by using chemical reaction. A CVD apparatus injects a highpressure reaction gas into a vacuum chamber to grow a film of the reaction gas on a heated substrate in the chamber.

Currently, due to the development of micro semiconductor devices and highly efficient light emitting diodes (LEDs) having large outputs, a CVD method such as a metal organic chemical vapor deposition (MOCVD) method is attracting people. As chambers and susceptors are getting larger to simultaneously perform deposition on a plurality of deposition targets, a technology of uniformly forming a thin film on a plurality of deposition targets has become a core technology. In this case, deposition targets are disposed on satellite disks and the satellite disks are individually accommodated in a plurality of pockets formed in a susceptor. In order to uniformly grow a thin film on the deposition targets, the susceptor itself rotates and the satellite disks on which the deposition targets are disposed also rotate.

### SUMMARY

Provided are susceptors having improved structures to increase durability, and chemical vapor deposition (CVD) apparatuses including the same.

Additional aspects will be set forth in part in the description which follows and, in part, will be apparent from the description, or may be learned by practice of the presented embodiments.

According to an aspect of the present invention, a susceptor for a chemical vapor deposition (CVD) apparatus has a shape of a disk with a hollow and includes a plurality of pockets formed in an upper surface of the susceptor to accommodate deposition targets; and susceptor channels formed in the susceptor to supply a flowing gas to the plurality of pockets, wherein inlets of the susceptor channels are formed in a sidewall of the hollow.

In this case, the susceptor channels may linearly extend from the inlets to portions below the pockets and then be bent from the portions below the pockets to outlets formed in the pockets.

According to another aspect of the present invention, a susceptor for a chemical vapor deposition (CVD) apparatus has a shape of a disk with a hollow and includes a plurality of pockets formed in an upper surface of the susceptor to accommodate deposition targets; and susceptor channels formed in the susceptor to supply a flowing gas to the plurality of pockets, wherein inlets of the susceptor channels are formed in a lower surface of the susceptor, and wherein a reinforcement unit is formed on the upper surface of the susceptor to correspond to the inlets of the susceptor channels.

In this case, the inlets of the susceptor channels may be formed along a circle around a center of the susceptor, and the reinforcement unit may protrude from a circular region on the upper surface of the susceptor to correspond to the inlets of the susceptor channels.

The reinforcement unit may protrude from and be integrally formed with the susceptor.

The plurality of pockets may be spaced apart from each other, and an edge along a circumference of each of the plurality of pockets may be continuous.

The plurality of pockets may overlap each other, an edge along a circumference of each of the plurality of pockets may be discontinuous to have discontinuous portions, and at least the discontinuous portions may have round cross sections. In this case, the round cross sections of the discontinuous portions may have a curvature radius of 0.7mm to 1.3mm.

The susceptor may be hard-coated. In this case, the susceptor is formed by coating silicon carbide (SiC) on graphite.

According to another aspect of the present invention, a chemical vapor deposition (CVD) apparatus includes a susceptor having a shape of a disk with a hollow; and a supporting unit for supporting the susceptor and injecting a flowing gas into the susceptor to rotate deposition targets, wherein the susceptor includes a plurality of pockets formed in an upper surface of the susceptor to accommodate the deposition targets; and susceptor channels formed in the susceptor to supply the flowing gas to the plurality of pockets, and wherein inlets of the susceptor channels are formed in a sidewall of the hollow such that the supporting unit injects the flowing gas from the sidewall of the hollow of the susceptor.

The susceptor channels may linearly extend from the inlets to portions below the pockets and then be bent from the portions below the pockets to outlets formed in the pockets.

According to another aspect of the present invention, a chemical vapor deposition (CVD) apparatus includes a susceptor having a shape of a disk with a hollow; and a supporting unit for supporting the susceptor and injecting a flowing gas into the susceptor to rotate deposition targets, wherein the susceptor includes a plurality of pockets formed in an upper surface of the susceptor to accommodate the deposition targets; and susceptor channels formed in the susceptor to supply the flowing gas to the plurality of pockets, wherein inlets of the susceptor channels are formed in a lower surface of the susceptor such that the supporting unit injects the flowing gas from the lower surface of the susceptor, and wherein a reinforcement unit is formed on the upper surface of the susceptor to correspond to the inlets of the susceptor channels.

The inlets of the susceptor channels may be formed along a circle around a center of the susceptor, and the reinforcement unit may protrude from a circular region on the upper surface of the susceptor to correspond to the inlets of the susceptor channels.

### BRIEF DESCRIPTION OF THE DRAWINGS

These and/or other aspects will become apparent and more readily appreciated from the following description of the embodiments, taken in conjunction with the accompanying drawings of which:
FIG. 1 is a cross-sectional view of a chemical vapor deposition (CVD) apparatus according to an embodiment of the present invention;
FIG. 2 is a perspective cross-sectional view of a susceptor and components coupled to the susceptor in the CVD apparatus illustrated in FIG. 1;
FIG. 3 is a cross-sectional view of a susceptor according to a comparative example;
FIG. 4 is a cross-sectional view for describing a breakage occurring in the susceptor illustrated in FIG. 3;
FIG. 5 is a plan view of the susceptor of the CVD apparatus illustrated in FIG. 1;
FIG. 6 is a perspective cross-sectional view of a susceptor of the CVD apparatus illustrated in FIG. 1, according to another embodiment of the present invention;
FIG. 7 is a plan view of the susceptor illustrated in FIG. 6;
FIG. 8 is a cross-sectional view taken along a line C-C' of FIG. 7;
FIG. 9 is a cross-sectional view of a CVD apparatus according to another embodiment of the present invention; and
FIG. 10 is a perspective cross-sectional view of a susceptor and components coupled to the susceptor in the CVD apparatus illustrated in FIG. 9.

### DETAILED DESCRIPTION

Reference will now be made in detail to embodiments, examples of which are illustrated in the accompanying drawings, wherein like reference numerals refer to the like elements throughout. In this regard, the present embodiments may have different forms and should not be construed as being limited to the descriptions set forth herein. Accordingly, the embodiments are merely described below, by referring to the figures, to explain aspects of the present description.

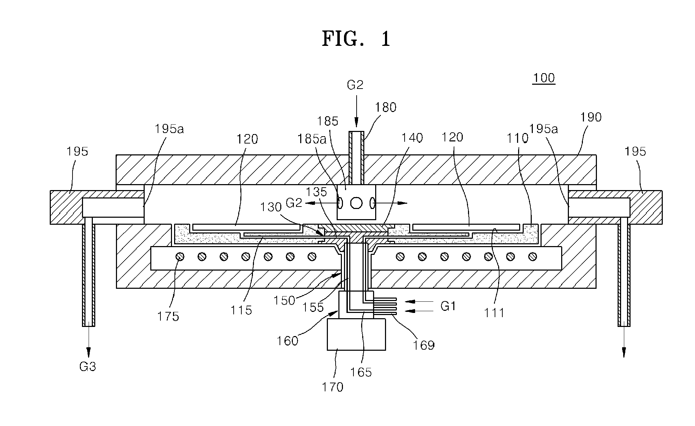

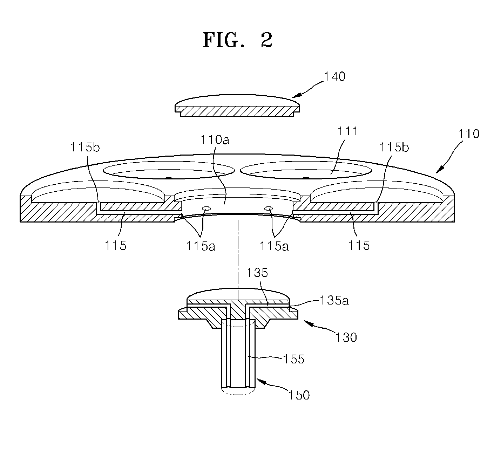

FIG. 1 is a cross-sectional view of a chemical vapor deposition (CVD) apparatus 100 according to an embodiment of the present invention. FIG. 2 is a perspective cross-sectional view of a susceptor 110 and components coupled to the susceptor 110 in the CVD apparatus 100 illustrated in FIG. 1.

Referring to FIGS. 1 and 2, the CVD apparatus 100 includes the susceptor 110, a supporting unit (130, 140, and 150) for supporting the susceptor 110 and injecting a flowing gas G1 into the susceptor 110, a heater 175 for heating the susceptor 110, a reaction gas injection unit 180 for supplying a reaction gas G2, a chamber 190 for accommodating the susceptor 110 and a nozzle 185 of the reaction gas injection unit 180, and a gas discharging unit 195 for discharging the flowing gas G1 and the reaction gas G2 filled in the chamber 190.

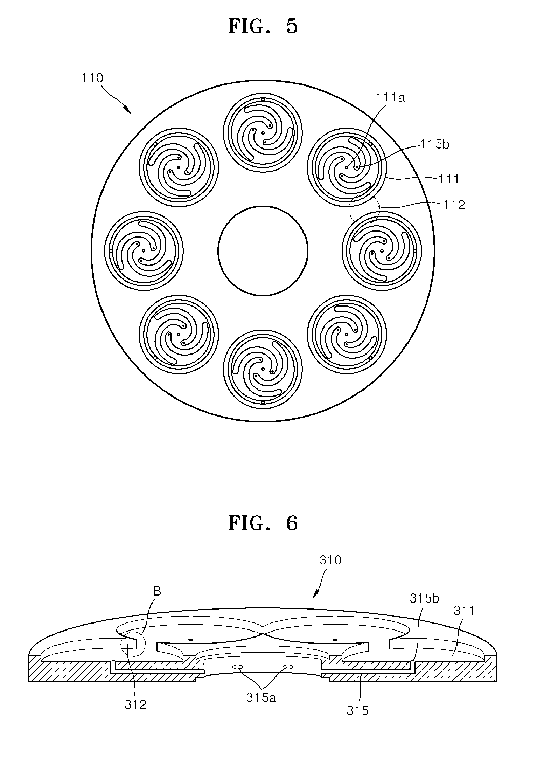

The susceptor 110 may have a shape of a disk with a hollow 110a. A plurality of the pockets 111 are formed in an upper surface of the susceptor 110. As illustrated in FIG. 5, the pockets 111 may be aligned along a circle around the center of the susceptor 110 to be equally spaced apart from each other. Although six pockets 111 are formed in FIG. 2 and eight pockets 111 are formed in FIG. 5, six and eight are exemplary numbers of pockets 111 and the number of pockets 111 may vary according to the size of the susceptor 100 and the size of the pockets 111. In some cases, the pockets 111 may be aligned in a plurality of rows. Each of the pockets 111 is a recess sunken from the upper surface of the susceptor 110 to a predetermined depth. Satellite disks 120 are accommodated in the pockets 111. Protrusions 111 a (see FIG. 5) for preventing the satellite disks 120 from being separated from the pockets 111 while rotating may be formed at the centers of the pockets 111. At least one outlet 115b for releasing the flowing gas G2 is formed in a bottom surface of each of the pockets 111. Since the flowing gas G1 released from the outlets 115b produces a cushioning effect, the frictional force between the satellite disks 120 and the bottom surfaces of the pockets 111 when the satellite disks 120 rotate may be very small and thus may be ignored. Also, patterns for allowing the flowing gas G1 released from the outlets 115b to rotate in a predetermined direction are formed in the bottom surfaces of the pockets 111, such that the satellite disks 120 may rotate.

Deposition targets such as wafers are disposed on the satellite disks 120. A rim (not shown) may be formed along a circumference of each of the satellite disks 120 so as to prevent movement of the deposition targets.

Susceptor channels 115 for supplying the flowing gas G1 to the pockets 111 are formed in the susceptor 110. Inlets 115a of the susceptor channels 115 are formed in a sidewall of the hollow 110a of the susceptor 110. Meanwhile, the outlets 115b of the susceptor channels 115 are formed in the bottom surfaces of the pockets 111. The number of susceptor channels 115 may correspond to the number of pockets 111. One susceptor channel 115 may be divided to a plurality of outlets 115b. Since the inlets 115a of the susceptor channels 115 are formed in the sidewall of the hollow 110a of the susceptor 110, the susceptor channels 115 linearly extend from the inlets 115a to portions below the pockets 111 and then are bent from the portions below the pockets 111 to the outlets 115b formed in the pockets 111.

Meanwhile, a material for forming the susceptor 110 may vary according to a method of heating the deposition targets disposed on the satellite disks 120. If an induction heating method is used, the susceptor 110 may be formed of a material that may be heated by using the induction heating method. For example, the susceptor 110 may be formed of graphite. The susceptor 110 may be hard-coated to increase the durability of the susceptor 110. For example, the susceptor 110 may be formed by coating silicon carbide (SiC) on graphite. Since the susceptor 110 is self-heated to heat the deposition targets, the susceptor 110 may be damaged by thermal impact. However, the damage of the susceptor 110 may be reduced by improving the structure of the susceptor 110 as described below.

The supporting unit for supporting the susceptor 110 includes a supporting disk 130 disposed at a lower potion of the susceptor 110, an upper coupling plate 140 disposed at an upper portion of the susceptor 110, and a supporting tube 150 coupled to the supporting disk 130 to function as a rotation shaft. The upper coupling plate 140 and the supporting disk 130 may be coupled to each other by using a well-known coupling means, and the susceptor 110 fitted between the upper coupling plate 140 and the supporting disk 130 is fixed on the supporting disk 130. The supporting disk 130 is coupled to the supporting tube 150 and the supporting tube 150 is connected to a flowing gas injection unit 160.

Meanwhile, supporting disk channels 135 through which the flowing gas G1 flows are formed in the supporting disk 130. The supporting disk channels 135 are connected to supporting tube channels 155 of the supporting tube 150, and outlets 135a of the supporting disk channels 135 are formed in an outer circumference of the supporting disk 130. If a portion of the supporting disk 130 is inserted into the hollow 110a of the susceptor 110, the outlets 135a of the supporting disk channels 135 face the inlets 115a of the susceptor channels 115. Although the outlets 135a of the disk channels 135 one-to-one correspond to the inlets 115a of the susceptor channels 115 in FIG. 2, the connection structure between the outlets 135a and the inlets 115a is not limited thereto. Alternatively, neiboring inlets 115a of the susceptor channels 115 may be connected to each other and then be connected to one outlet 135a of the disk channels 135. A material for forming the supporting disk 130 is not restrictive. For example, the supporting disk 130 may be formed of metal.

The supporting tube 150 may be a hollow shaft or a rod. The supporting tube channels 155 are formed in the supporting tube 150 and are connected to injection unit channels 165 of the flowing gas injection unit 160.

The flowing gas injection unit 160 is connected to flowing gas supply lines 169 to inject the flowing gas G1 into the supporting tube channels 155 of the supporting tube 150, and transfers rotatory power of a driving motor 170 to the supporting tube 150. In this case, in order to maintain the chamber 190 to be sealed, ferrofluid sealing may be performed on a gap between the chamber 190 and a rotation part of the flowing gas injection unit 160.

Meanwhile, the flowing gas G1 may be, for example, nitrogen, and rotation of the satellite disks 120 may be actively controlled by adjusting a flow rate of the flowing gas G1 supplied to the flowing gas supply lines 169. Furthermore, rotation of the satellite disks 120 may be differently controlled by adjusting the flow rate of the flowing gas G1 supplied to each or some of the pockets 111.

The heater 175 heats the susceptor 110 to a predetermined temperature. The heater 175 may heat the susceptor 110 to a temparature equal to or greater than several hundrads to 1000°C. For example, in order to grow a gallium nitride (GaN)-based layer, the heater 175 may heat the susceptor 110 to about 700 to 1300°C. The heater 175 may be coil to which a high-frequency current is applied and, in this case, the susceptor 110 may be heated by using an induction heating method. Alternatively, the heater 175 may be a conducting wire that generates resistance-heat.

The reaction gas injection unit 180 is a device for supplying the reaction gas G2 including a carrier gas and a source gas to be deposited on the deposition targets. The nozzle 185 of the reaction gas injection unit 180 is exposed in the chamber 190 and the reaction gas G2 is discharged through nozzle holes 185a of the nozzle 185.

The deposition targets are maintained at a high temperature due to the highly heated susceptor 110, and chemical deposition reaction occurs on upper surfaces of the deposition targets which contact the reaction gas G2. Due to the chemical deposition reaction, a predetermined material such as a GaN-based compound crystal-grows on the deposition targets such as wafers.

The chamber 190 accommodates the susceptor 110 and the nozzle 185 of the reaction gas injection unit 180, and may be sealed in a deposition process and may be open to replace the deposition targets.

The gas discharging unit 195 discharges the flowing gas G1 and the reaction gas G2 filled in the chamber 190.

Improvements of the CVD apparatus 100 will now be described by comparing it with a CVD apparatus according to a comparative example.

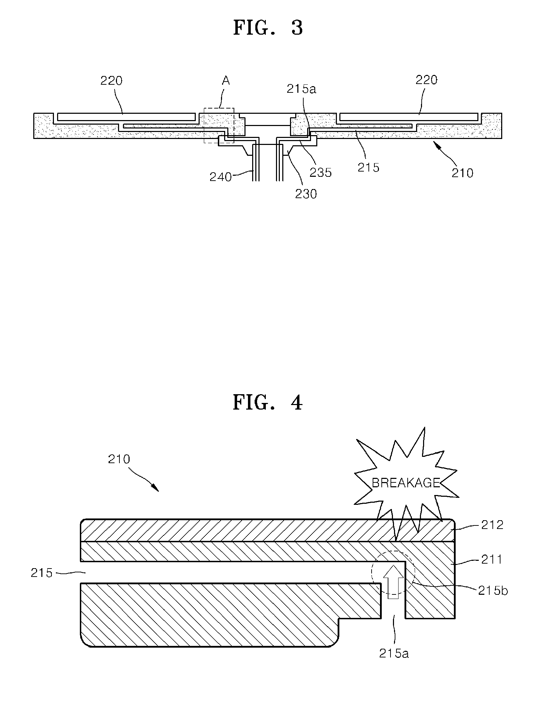

FIG. 3 is a cross-sectional view of a susceptor 210 according to a comparative example. FIG. 4 is a cross-sectional view for describing a breakage occurring in the susceptor 210 illustrated in FIG. 3. The susceptor 210 is one of commertiallized products. Referring to FIGS. 3 and 4, inlets 215a of susceptor channels 215 are formed in a lower surface of the susceptor 210 and thus the susceptor channels 215 proceed upward from the lower surface of the susceptor 210, are bent in horizontal directions, and then are bent upward from portions below pockets 211. The susceptor 210 is hard-coated to increase the durability of the susceptor 210 by coating an SiC layer 212 on a graphite layer 211. However, since the susceptor channels 215 are perpendicularly bent near the inlets 215a, the perpendicularly bent portions of the susceptor channels 215 near the inlets 215a continuously receive thermal impact by the flowing gas G1 injected from a supporting tube 250. Meanwhile, the susceptor 210 is heated to, for example, about 1000 to 1300°C for deposition while the flowing gas G1 is injected at a low temperature, for example, about room temperature. Accordingly, since the perpendicularly bent portions of the susceptor channels 215 near the inlets 215a continuously receive thermal impact, although the susceptor 210 is hard-coated to increase the durability of the susceptor 210 by coating the SiC layer 212 on the graphite layer 211, the perpendicularly bent portions of the susceptor channels 215 near the inlets 215a may be broken. Due to the breakage, the life of the susceptor 210 may end after being used about 20 to 30 times, the susceptor 210 that is relatively expensive has to be replaced freqently, and thus a manufacturing cost may be incrased.

On the other hand, in the susceptor 110 illustrated in FIGS. 1 and 2, paths of the susceptor channels 115 are different from those of the susceptor channels 215. That is, in the susceptor 110 including the susceptor channels 115, the flowing gas G1 is horizontally injected. In more detail, since the inlets 115a are formed in the sidewall of the hollow 110a of the susceptor 110, the susceptor channels 115 linearly extend from the inlets 115a to the portions below the pockets 111. Accordingly, thermal impact caused in the susceptor 210 does not occur and thus breakages do not occur near the inlets 115a.

As described above, in comparison to the susceptor 210, the life of the susceptor 110 may be greatly extended by suppressing breakages near the inlets 115a, and a manufacturing cost of the CVD apparatus 100 including the susceptor 110 may be reduced.

Furthermore, in the susceptor 110, the pockets 111 are equally spaced apart from each other as illustrated in FIG. 5. Since the pockets 111 are sunken from the upper surface of the susceptor 110, the pockets 111 are stepped into the susceptor 110 to form edges along circumferences of the pockets 111. As described above in relation to FIG. 1, the reaction gas G2 is injected into the chamber 190 through the nozzle 185 of the reaction gas injection unit 180, and contact upper surfaces of the deposition target disposed on the satellite disks 120. In this case, the reaction gas G2 continuously crashes against the edges along the circumferences of the pockets 111 for accommodating the satellite disks 120. However, since the susceptor 110 is heated to a high temperature to heat the deposition targets, the edges along the circumferences of the pockets 111 may continuously receive thermal impact by the reaction gas G2.

In a general commercialized susceptor, a plurality of pockets overlap each other as illustrated in FIG. 6 to align deposition targets as many as possible in a limited area, and thus edges along circumferences of the pockets may be partially cut. The cut edges have a very small thickness and thus may be easily broken due to thermal impact by the reaction gas G2. If the cut edges are broken, satellite disks may vibrate while rotating and may be separated from their original positions, and thus the susceptor itself may not be used any further.

Unlike the general commercialized susceptor, in the susceptor 110 illustrated in FIGS. 1 and 2, the pockets 111 are spaced apart from each other and thus the edges along the circumferences of the pockets 111 are not cut and are continuously formed. Accordingly, as illustrated in FIG. 5, even in a region 112 where two pockets 111 are closest to each other, the edges may not be broken and be constantly maintained against thermal impact by the reaction gas G2, and thus the life of the susceptor 110 may be greatly increased.

However, the CVD apparatus 100 is not limited to a structure in which the pockets 111 are spaced apart from each other as described above.

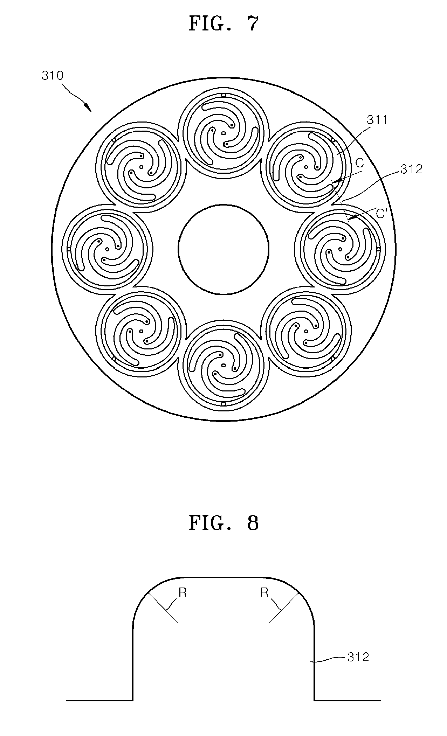

FIG. 6 is a perspective cross-sectional view of a susceptor 310 of the CVD apparatus 100 illustrated in FIG. 1, according to another embodiment of the present invention. FIG. 7 is a plan view of the susceptor 310 illustrated in FIG. 6. FIG. 8 is a cross-sectional view taken along a line C-C' of FIG. 7.

Referring to FIGS. 6 through 8, in the susceptor 310, a plurality of pockets 311 overlap each other. That is, as illustrated in FIG. 7, the pockets 311 may be aligned along a circle around the center of the susceptor 310 to overlap each other. In this case, the overlapping portions of the pockets 311 are open to each other and edges along circumferences of the pockets 311 are cut in overlapping regions (e.g., a region B in FIG. 6) to form cut portions 312. The cut portions 312 may be vulnerable to thermal impact by the reaction gas G2. As such, in the susceptor 310, at least edges of the cut portions 312 may be rounded such that the reaction gas G2 may not crash against the edges of the cut portions 312 but smoothly flow along the rounded cut portions 312, thereby greatly reducing breakages of the cut portions 312. For example, if the edges of the cut portions 312 are rounded with a curvature radius of 1 mm, in comparison to a case of a curvature radius of 0.5mm, the life of the susceptor 310 is at least doubled. Accordingly, in the susceptor 310, the edges of the cut portions 312 may be rounded with a curvature radius of about 1 ±0.3mm. That is, the rounded edges of the cut portions 312 may have a curvature radius R of 0.7mm to 1.3mm. The rounding is not limited to be performed on the edges of the cut portions 312 and may be entirely performed on edges along circumferences of the pockets 311.

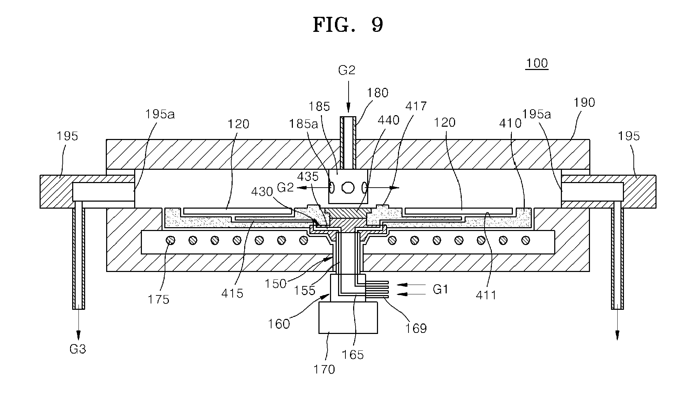

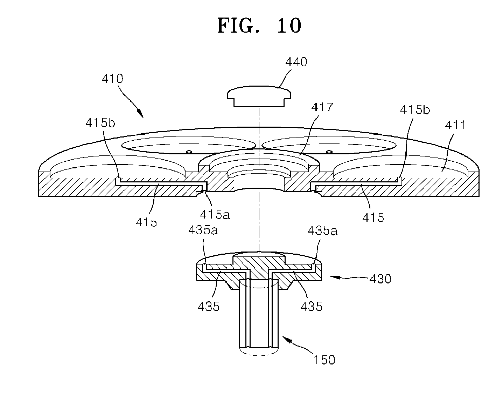

FIG. 9 is a cross-sectional view of a CVD apparatus 400 according to another embodiment of the present invention. FIG. 10 is a perspective cross-sectional view of a susceptor 410 and components connected to the susceptor 410 in the CVD apparatus 400 illustrated in FIG. 9.

Referring to FIGS. 9 and 10, the CVD apparatus 400 includes the susceptor 410, a supporting unit (430, 440, and 450) for supporting the susceptor 410 and injecting the flowing gas G1 into the susceptor 410, a heater 175 for heating the susceptor 410, the reaction gas injection unit 180 for supplying the reaction gas G2, the chamber 190 for accommodating the susceptor 410 and the nozzle 185 of the reaction gas injection unit 180, and the gas discharging unit 195 for discharging the flowing gas G1 and the reaction gas G2 filled in the chamber 190.

In the susceptor 410, inlets 415a of susceptor channels 415 are formed in a lower surface of the susceptor 410. As such, the susceptor channels 415 proceed upward from the lower surface of the susceptor 410, are bent in horizontal directions, and then are bent upward from portions below pockets 411. As such, outlets 435a of supporting disk channels 435 of a supporting disk 430, which are connected to the inlets 415a of the susceptor channels 415, are formed in an upper surface of the supporting disk 430.

If the susceptor channels 415 are bent near the inlets 415a of the susceptor channels 415 as described above, the possibility of damaging the susceptor 410 may be increased. As such, the susceptor 410 includes a reinforcement unit 417 to reduce the possibility of damaging the susceptor 410. The reinforcement unit 417 is formed on an upper surface of the susceptor 410 to correspond to the inlets 415a of the susceptor channels 415. The inlets 415a of the susceptor channels 415 may be formed along a circle around the center of the susceptor 410, and the reinforcement unit 417 may protrude from a circular region on the upper surface of the susceptor 410 to correspond to the inlets 415a of the susceptor channels 415. The reinforcement unit 417 may protrude from and be integrally formed with the susceptor 410. In some cases, the reinforcement unit 417 may be separately formed and then bonded onto the susceptor 410. Furthermore, a plurality of reinforcement units 417 may be formed to individually correspond to the inlets 415a of the susceptor channels 415. In this case, the height of the reinforcement unit 417 may be designed not to disturb the flow of the reaction gas G2 released from the nozzle 185 of the reaction gas injection unit 180.

The susceptor 410 may be formed by coating SiC on a graphite layer. In this case, the reinforcement unit 417 may protrude from the graphite layer and SiC may be coated on the graphite layer from which the reinforcement unit 417 protrudes. In some cases, a planarization layer may be further formed to planarize the upper surface of the susceptor 410. If the susceptor 410 is formed by coating SiC on the graphite layer, the upper surface of the susceptor 410 may be planarized by using a chemical mechanical polishing (CMP) method, a lapping method, or the like.

Except for the susceptor 410 and channel structures of the supporting unit for supporting the susceptor 410, the CVD apparatus 400 is substantially the same as the CVD apparatus 100 illustrated in FIGS. 1 and 2. Furthermore, the susceptor 310 illustrated in FIGS. 6 through 8 is also applied to the CVD apparatus 400. Repeated descriptions will not be provided here.

As described above, according to one or more of the above embodiments of the present invention, a susceptor and a chemical vapor deposition (CVD) apparatus including the same have the following effects.

First, breakages of the susceptor near inlets of a flowing gas may be prevented by improving the structure of gas channels of the susceptor.

Second, breakages of the susceptor near pockets may be prevented by improving the structure of circumferences of the pockets.

Third, a long life of a susceptor may be ensured, and productivity and deposition quality may be improved.

It should be understood that the exemplary embodiments described therein should be considered in a descriptive sense only and not for purposes of limitation. Descriptions of features or aspects within each embodiment should typically be considered as available for other similar features or aspects in other embodiments.

## Claims

1. A susceptor for a chemical vapor deposition (CVD) apparatus, the susceptor having a shape of a disk with a hollow and comprising:
a plurality of pockets formed in an upper surface of the susceptor to accommodate deposition targets; and
susceptor channels formed in the susceptor to supply a flowing gas to the plurality of pockets,
wherein inlets of the susceptor channels are formed in a sidewall of the hollow.

2. The susceptor of claim 1, wherein the susceptor channels linearly extend from the inlets to portions below the pockets and then are bent from the portions below the pockets to outlets formed in the pockets.

3. The susceptor of claim 1 or 2, wherein the plurality of pockets are spaced apart from each other, and
wherein an edge along a circumference of each of the plurality of pockets is continuous.

4. The susceptor of claim 1 or 2, wherein the plurality of pockets overlap each other,
wherein an edge along a circumference of each of the plurality of pockets is discontinuous to have discontinuous portions, and
wherein at least the discontinuous portions have round cross sections.

5. The susceptor of claim 4, wherein the round cross sections of the discontinuous portions have a curvature radius of 0.7mm to 1.3mm.

6. The susceptor of any one of claims 1 through 5, wherein the susceptor is hard-coated.

7. The susceptor of claim 6, wherein the susceptor is formed by coating silicon carbide (SiC) on graphite.

8. A chemical vapor deposition (CVD) apparatus comprising:
a susceptor having a shape of a disk with a hollow; and
a supporting unit for supporting the susceptor and injecting a flowing gas into the susceptor to rotate deposition targets,
wherein the susceptor comprises:
a plurality of pockets formed in an upper surface of the susceptor to accommodate the deposition targets; and
susceptor channels formed in the susceptor to supply the flowing gas to the plurality of pockets, and
wherein inlets of the susceptor channels are formed in a sidewall of the hollow such that the supporting unit injects the flowing gas from the sidewall of the hollow of the susceptor.

9. The CVD apparatus of claim 8, wherein the susceptor channels linearly extend from the inlets to portions below the pockets and then are bent from the portions below the pockets to outlets formed in the pockets.

10. The CVD apparatus of claim 8 or 9, wherein the plurality of pockets are spaced apart from each other, and
wherein an edge along a circumference of each of the plurality of pockets is continuous.

11. The CVD apparatus of claim 8 or 9, wherein the plurality of pockets overlap each other,
wherein an edge along a circumference of each of the plurality of pockets is discontinuous to have discontinuous portions, and
wherein at least the discontinuous portions have round cross sections.

12. The CVD apparatus of claim 11, wherein the round cross sections of the discontinuous portions have a curvature radius of 0.7mm to 1.3mm.
